(19) Europäisches Patentamt
European Patent Office
Office européen des brevets

(11) **EP 4 099 032 B1**

(12) **EUROPEAN PATENT SPECIFICATION**

(45) Date of publication and mention
of the grant of the patent:
**20.12.2023 Bulletin 2023/51**

(21) Application number: **21305753.2**

(22) Date of filing: **04.06.2021**

(51) International Patent Classification (IPC):
**G01R 31/26** (2020.01)   **G01R 31/40** (2020.01)
**G01K 7/01** (2006.01)   **H02M 1/088** (2006.01)
**H02M 1/32** (2007.01)

(52) Cooperative Patent Classification (CPC):
**G01R 31/2642; G01K 7/01; H02M 1/32;**
G01R 31/2619; G01R 31/2628; G01R 31/263;
G01R 31/40; H02M 1/088; H02M 1/327

(54) **A METHOD AND A DEVICE FOR INCREASING THE LIFETIME OF POWER DIES OR POWER MODULES**

VERFAHREN UND VORRICHTUNG ZUR ERHÖHUNG DER LEBENSDAUER VON LEISTUNGSCHIPS ODER LEISTUNGSMODULEN

PROCÉDÉ ET DISPOSITIF PERMETTANT D'AUGMENTER LA DURÉE DE VIE DES PUCES DE PUISSANCE OU DES MODULES DE PUISSANCE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**07.12.2022 Bulletin 2022/49**

(73) Proprietors:
• **Mitsubishi Electric R & D Centre Europe B.V.**
**1119 NS Schiphol Rijk (NL)**
Designated Contracting States:
**FR**
• **Mitsubishi Electric Corporation**
**Tokyo 100-8310 (JP)**
Designated Contracting States:
**AL AT BE BG CH CY CZ DE DK EE ES FI GB GR HR HU IE IS IT LI LT LU LV MC MK MT NL NO PL PT RO RS SE SI SK SM TR**

(72) Inventors:
• **OUHAB, Merouane**
**35700 Rennes (FR)**
• **DEGRENNE, Nicolas**
**35700 Rennes (FR)**
• **PICHON, Pierre-Yves**
**35700 Rennes (FR)**
• **BRANDELERO, Julio Cezar**
**35700 Rennes (FR)**

(74) Representative: **Cabinet Le Guen Maillet**
**3, impasse de la Vigie**
**CS 71840**
**35418 Saint-Malo Cedex (FR)**

(56) References cited:
**EP-A1- 3 054 306     US-A1- 2020 236 823**

• **RUTHARDT JOHANNES ET AL: "Closed Loop Junction Temperature Control of Power Transistors for Lifetime Extension", 2020 IEEE APPLIED POWER ELECTRONICS CONFERENCE AND EXPOSITION (APEC), IEEE, 15 March 2020 (2020-03-15), page 2955, XP033784544, DOI: 10.1109/APEC39645.2020.9124000 [retrieved on 2020-06-23]**
• **MICHEL MERMET-GUYENNET ET AL: "Railway traction reliability", INTEGRATED POWER ELECTRONICS SYSTEMS (CIPS), 2010 6TH INTERNATIONAL CONFERENCE ON, IEEE, 16 March 2010 (2010-03-16), pages 1-6, XP031930482, ISBN: 978-1-61284-814-3**

EP 4 099 032 B1

# EP 4 099 032 B1

**Description**

TECHNICAL FIELD

The present invention relates generally to a method and a device for increasing the lifetime of power dies or power modules.

RELATED ART

Classically, power dies or power modules are connected in parallel. The degradation of several power dies or power modules may occur at different rates due to process variabilities or geometrical asymmetries of power module design. Therefore, currently during the manufacturing, parallel connected power dies or power modules are typically sorted to present the same electro-thermo-mechanical characteristics. Equalizing the degradation of parallel power dies is beneficial for the lifetime of the system comprising such power dies or power modules because the reliability would not depend on the most critical component and avoid the sorting process.

In an extreme scenario, the connection of heterogeneous power dies or power modules would typically lead to high variabilities in degradation rates and even degradation modes. Heterogeneous power dies or power modules is for example a difference in technology such as SiC MOSFET and Si IGBT and/or a difference in die sizes and/or a difference in interconnection technology, etc.

In practice, connecting in parallel heterogeneous power dies and/or modules can be beneficial in terms of performance such as efficiency, but is difficult due to the electro-thermo-mechanical differences which lead to unbalancing and to issue in reliability and robustness. Equalizing the degradation would thus remove an important bottleneck for this kind of heterogeneous assembly.

In the prior art, some methods are presented to adjust the switching events of heterogeneous (e.g. parallel SiC MOSFETs and Si IGBT) power modules in order to improve the overall performances such as balancing the temperatures. The switching patterns are determined based on *a priori* knowledge of the electro-thermal performances. This kind of approach requires a pre-characterization of the electro-thermal performances of each power die or power module. In addition, when the temperature evolves and/or a degradation appears, the pre-characterization is not valid anymore because of the effect of the degradation on the electro-thermal parameters. As a consequence, this kind of 'open-loop' approach leads to high cost and low performances.

In the prior art, some methods monitor a temperature sensitive electrical parameter and delay the turn-on of the hottest power die and/or the hottest power module in order to reduce their losses and equilibrate the temperatures. Furthermore, US 2020 236823 A1 is related to characterising power semiconductor modules. EP 3 054 306 A1 is related to controlling the temperature of a multi-die power module. On the other side, RUTHARDT JOHANNES ET AL: "Closed Loop Junction Temperature Control of Power Transistors for Lifetime Extension", 2020 IEEE APPLIED POWER ELECTRONICS CONFERENCE AND EXPOSITION (APEC), IEEE, 15 March 2020, page 2955, XP033784544, DOI: 10.1109/APEC39645.2020.9124000 shows an approach for closed loop junction temperature control of power transistors for lifetime extension. Lastly, MICHEL MERMET-GUYENNET ET AL: "Railway traction reliability", INTEGRATED POWER ELECTRONICS SYSTEMS (CIPS), 2010 6TH INTERNATIONAL CONFERENCE ON, IEEE, 16 March 2010, pages 1-6, XP031930482, ISBN: 978-1-61284-814-3 is related to a method for lifetime prediction for power converters in traction.

Such algorithms are efficient to balance the temperature of power modules with thermal unbalance. In the case of a strong electrical or reliability unbalance, this kind of algorithm is not adapted to improve performance indicators such as the efficiency and/or reliability indicators such as the lifetime. Indeed, balancing the temperature does not balance the lifetime in the case of power dies or power modules with different reliability figures because of the variability in degradation rates or degradation modes and manufacturing process deviations.

SUMMARY OF THE INVENTION

The present invention aims to provide a method and a device which enable gate-controlled equilibration of the degradation of several parallel power dies and/or modules in order to achieve a higher level of reliability and robustness. Additionally, this invention enables new business cases: retrofitting, second use, valorisation of different components and technologies.

To that end, the present invention concerns a method for increasing the lifetime of at least two power dies or power modules as defined in claim 1.

The present invention concerns also a system for increasing the lifetime of at least two power dies or power modules as defined in claim 11.

Thus, the degradation level can be monitored, controlled and balanced between parallelly connected power dies or power modules of the same or different technology, allowing an increase of the global system lifetime.

2

According to a particular feature, for each power die or power module, the temperature cycle is equal to the temperature difference between the last sensed local maximum temperature and an initial temperature that is determined as a last local minimum temperature.

Thus, the temperature cycle or variation can be determined continuously during operating conditions in order to be used as a stress input for the reliability parameter of each single power die or power module.

According to a particular feature, the reliability parameters R1 and R2 are determined as:

$$R1 = \alpha_1 . \Delta T$$

$$R2 = \alpha_2 . \Delta T_2^{\beta_2}$$

where $\alpha_1$, $\alpha_2$, $\beta_1$, and $\beta_2$ are reliability constants that can be determined from power cycling tests and fitted on testing data provided by the manufacturer of the power dies or power modules, $\Delta T_1$ and $\Delta T_2$ are the respective temperature cycles of the power dies or power modules.

Thus, the reliability parameter of each power die or power module can be determined continuously under operating conditions based on the calculated temperature cycles. Moreover, the reliability parameters are then used for the determination of the reference temperature of each power die or power module.

According to a particular feature, the reference temperature of one power die or power module is determined assuming that a ratio between the temperature cycle amplitudes is equal to the ratio between the junction temperature of the power dies or power modules to ambient temperature and by equalizing the reliability parameters of the power dies or power modules, the temperature reference of the other power die or power module being determined as equal to the sensed temperature of the other power die or power module.

Thus, the reference temperature is determined for each power die or power module in order to control their degradation level continuously under operating conditions.

According to a particular feature, the reliability parameters are determined from lifetime models *Nf*1 and *Nf*2 that can be expressed as:

$$Nf1 = \alpha_1 . \Delta T_1^{\beta_1}$$

$$Nf2 = \alpha_2 . \Delta T_2^{\beta_2}$$

where $\alpha_1$, $\alpha_2$, $\beta_1$ and $\beta_2$ are reliability constants that can be determined from power cycling tests and fitted on testing data provided by the manufacturer of the power dies or power modules, $\Delta T_1$ and $\Delta T_2$ are the respective temperature cycles of the power dies or power modules and the reliability parameters R1 and R2 are determined as:

$$R1 = \sum_{i=1}^{i=N} \frac{n_i(\Delta T_1)}{Nf1(\Delta T_1)}$$

$$R2 = \sum_{i=1}^{i=N} \frac{n_i(\Delta T_2)}{Nf2(\Delta T_2)}$$

where $n_i(\Delta T_1)$ and $n_i(\Delta T_2)$ represent the number of cycles at $\Delta T_1$ and $\Delta T_2$.

Thus, the reliability parameter of each power die or power module is correlated to a virtual degradation quantity that is evaluated continuously under operating conditions within for example an interval of [0, 1], or [0%, 100%]. Therefore, all the degradation levels between the healthy state and the failed state can be estimated.

According to a particular feature, the reference temperature of each power die or power module is determined by increasing or decreasing the temperature cycle of the power die or power module by an increment according to a comparison of the reliability and by summing the increased or decreased temperature cycle to a predetermined temperature.

Thus, the temperature of the parallelly connected power dies or power modules provides the ability to monitor and to control all the degradation levels in order to establish an equilibrium.

According to a particular feature, the reference temperature of each power die or power module is determined by calculating a damage change rate of the reliability parameter of the power die or power module, and by equilibrating the damage change rates, the damage change rates being calculating as:

$$\frac{\partial R1}{\partial t} = \frac{\partial \left( \frac{1}{\alpha_1} . \Delta T_1^{-\beta_1} \right)}{\partial t}$$

$$\frac{\partial R2}{\partial t} = \frac{\partial \left( \frac{1}{\alpha_2} . \Delta T_2^{-\beta_2} \right)}{\partial t}$$

and by determining, for each power die or power module, an increment of temperature that minimises the difference between the damage change rate of the power die or power module and the average value of the damage change rates and by summing the increment of temperature of the power die or power module to a predetermined temperature.

Thus, minimization of the difference between the damage change rates allows to minimise the difference between the damages or the degradation levels of each power die or power module. Therefore, the lifetime of the global system can be increased.

According to a particular feature, the reliability parameters are determined from *a priori* knowledge of a lifetime model as:

$$R1 = \frac{\ln(l_0 - a_{1,0}) - \ln(l_0 - a_{1,1})}{\gamma_1 \, \Delta T_1^2}$$

$$R2 = \frac{\ln(l_0 - a_{2,0}) - \ln(l_0 - a_{2,1})}{\gamma_2 \, \Delta T_2^2}$$

where $\gamma_1$ and $\gamma_2$ are determined from two different numbers of temperature cycles, $a_{1,0}$ and $a_{1,1}$ represent a length value change of a crack of a connection of a first power die, $a_{2,0}$ and $a_{2,1}$ represent a length value change of a crack of a connection of a second power die, $\Delta T_1$ is the temperature cycle of the first power die or power module and $\Delta T_2$ is the temperature cycle of the second power die or power module.

Thus, the reliability parameter of each power die or power module is identified based on the crack length measurement using an online or an offline mode. Therefore, no reliability testing data is needed to define the reliability parameter of each power die or power module.

According to a particular feature, the reference temperature of each power die or power module is determined by increasing or decreasing the temperature cycle of the power die or power module by an increment according to a comparison of the reliability and by summing the increased or decreased temperature cycle to a predetermined temperature.

Thus, the degradation level of each power die or power module is controlled and balanced based on the applied temperature cycle for each power die or power module.

According to a particular feature, the reliability parameters are determined from *a priori* knowledge of a lifetime model as:

$$\frac{da_1}{dN} = \gamma_1 . \Delta K_1^{\delta_1}$$

$$\frac{\mathrm{da_2}}{\mathrm{dN}} = \gamma_2 . \Delta K_2{}^{\delta_2}$$

where $\Delta K_1$ and $\Delta K_2$ are the stress intensity factors for the power dies that are function of the temperature cycles $\Delta T_1$ and $\Delta T_2$ respectively, and wherein an optimization is used in order to extend the system lifetime, so that the reference temperatures are calculated with the target to reach the failure criteria of the power dies at the same time using stress intensity factors of both power dies $\Delta K_{ref1}$ and $\Delta K_{ref2}$ calculated based on the solution of the following two main equations:

$$a_2(N_1) - a_1(N_1) = \int_{N_1}^{N_f} \gamma_1 . \Delta K_{ref1}{}^{\delta_1} dN - \int_{N_2}^{N_f} \gamma_2 . \Delta K_{ref2}{}^{\delta_2} dN$$

$$N_f - N_1 = \int_{a_1(N_1)}^{a_f} \frac{da_1}{\gamma_1 . \Delta K_{ref1}{}^{\delta_1}} = \int_{a_2(N_1)}^{a_f} \frac{da_2}{\gamma_2 . \Delta K_{ref2}{}^{\delta_2}}$$

where N1 represents a given number of cycles prior the system lifetime extension, N1 being selected between 1 and Nf which represents the number of cycles to failure of the power dies.

BRIEF DESCRIPTION OF THE DRAWINGS

The characteristics of the invention will emerge more clearly from a reading of the following description of example embodiments, the said description being produced with reference to the accompanying drawings, among which:

Fig. 1a represents a first example of a system for increasing the lifetime of power dies or power modules according to the invention;
Fig. 1b represents a second example of a system for increasing the lifetime of power dies or power modules according to the invention;
Fig. 1c represents a third example of a system for increasing the lifetime of power dies or power modules according to the invention;
Fig. 1d represents a fourth example of a system for increasing the lifetime of power dies or power modules according to the invention;
Fig. 1e represents a fifth example of a system for increasing the lifetime of power dies or power modules according to the invention;
Fig. 2 represents a sixth example of a system for increasing the lifetime of power dies or power modules according to the invention;
Fig. 3 represents an example of an algorithm executed according to the present invention.

DESCRIPTION

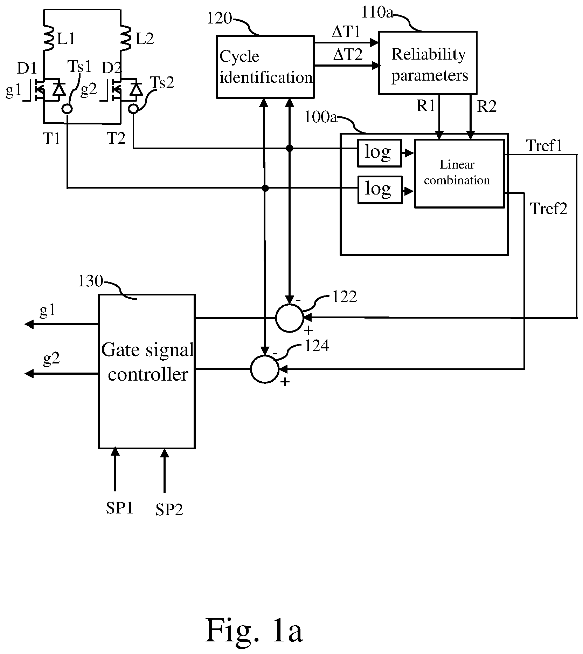

**Fig. 1a** represents a first example of a system for increasing the lifetime of power dies or power modules according to the invention.
In the example of Fig. 1a, the system comprises two power dies D1 and D2 that are electrically connected in parallel.
In Fig. 1a, only two power dies are shown for the sake of clarity. The present invention is also applicable for more than two power dies.
The power dies may be made of different materials such as silicon carbide (SiC) and silicon (Si) and/or of different structures such as metal oxide semiconductor field effect transistor (MOSFET) and insulated gate bipolar transistor (IGBT) and/or of different sizes, such as a $10mm^2$ area and $100mm^2$ area and/or of different types of interconnection such as solder and sintered die attach, or such as aluminium and copper wire-bonds.
The power dies may be replaced by power modules, each made of plural power dies in parallel.
In general, the heterogeneous power dies and/or modules present different electro-thermo-mechanical characteristics leading to different fatigue behaviour and reliability performance when connected in parallel.
The inductors L1 and L2 represent load inductors that represent the load of a motor.
For each power die D1, D2, the system comprises temperature sensing means Ts1 and Ts2.
The temperature sensing means Ts1 and Ts2 are temperature sensors located on or near each power die or a thermal sensitive electrical parameter of the power die. For example, the thermal sensitive electrical parameter is an internal gate resistance of the power die.

The temperature sensing means Ts1 provides a temperature value T1(t) of the power die D1. The temperature sensing means Ts2 provides a temperature value T2(t) of the power die D2. The temperature T1(t) and T2(t) are eventually filtered. The temperature values are provided to a reference temperature determination module 100a, to subtracting modules 122 and 124 and to a cycle identification module 120.

The reference temperature module 100a determines respectively, for each power die D1 and D2, a reference temperature Tref1 and Tref2 from the temperature values T1, T2 and from respective reliability parameters R1 and R2.

The reliability parameters are for example, reliability parameters provided by the data sheets of the respective power dies D1 and D2.

For example, the reliability parameters are determined by a reliability determination module 110a.

The reliability determination module 110a determines for each power die D1 and D2 from a temperature profile consisting in constant temperature swing $\Delta T_1$, $\Delta T_2$, the reliability parameters R1 and R2 as:

$$R1 = f(\Delta T_1, \alpha_1, \beta_1, \delta_1 \dots)$$

$$R2 = f(\Delta T_2, \alpha_2, \beta_2, \delta_2 \dots)$$

Such models allow calculating the reliability variable for laboratory cases where the stress variable $\Delta T_1$ and $\Delta T_2$ are controlled. More generally, most reliability models take temperature differences as input variable. This means, only at the end of a temperature cycle the damage can be estimated according to $R1 = f(\Delta T_1, \beta_1, \delta_1 \dots)$. and $R2 = f(\Delta T_2, \alpha_2, \beta_2, \delta_2 \dots)$.

In these expressions $\alpha_1$, $\beta_1$, $\delta_1 \dots$ are model constants determined by laboratory testing. $\Delta T_1$ and $\Delta T_2$ are determined by a cycle identification module 120 from the temperature values T1(t) T2(t). $\Delta T_1$ and $\Delta T_2$ represent typically the temperature cycle or the temperature variation between maximum and minimum values over an operation or a testing cycle period, i. e.:

$$\Delta T_i = \max(T_i(t)) - \min(T_i(t))$$

with: i=1, 2.

The value of $\min(T_i(t))$ (with: i=1, 2) may represent the start operating temperature, i. e.: $T_i(t_{start})$ (with: i=1, 2) which represents a reference temperature that is generally the coolest point over a cycle period.

For example, the reliability parameters R1 and R2 are:

$$R1 = \alpha_1 . \Delta T_1^{\beta_1}$$

$$R2 = \alpha_2 . \Delta T_2^{\beta_2}$$

where $\alpha_1$, $\alpha_2$, $\beta_1$ and $\beta_2$ are reliability constants that can be determined from power cycling (aging) tests, as they can be fitted on testing data provided by the manufacturer of the power die. As an example, these parameters can take the following values: $\alpha_1 = 1.5 \times 10^{14}$, $\alpha_2 = 2 \times 10^{14}$, $\beta_1 = -6$ and $\beta_2 = -4$.

The cycle identification module 120 determines the start of a temperature cycle $t_{start}$ for example, using the first derivative of the temperature profile that is evaluated at each discrete time interval $\Delta t$ between two consecutive temperature measurements. A sign change can be used to identify a local temperature minimum, hence the start of a temperature cycle is determined when:

$$\frac{T1(t-\Delta t)-T1(t-2\Delta t)}{\Delta t} < 0 \text{ and } \frac{T1(t)-T1(t-\Delta t)}{\Delta t} > 0 \text{ , then } t_{start} = t - \Delta t$$

The reliability functions R1 and R2 can be expressed as R1=f(max(T1(t))-T1(t_{start}), $\alpha_1$, $\beta_1$) R2=f(max(T2(t))-T2(t_{start}), $\alpha_2$, $\beta_2$) and are evaluated at discrete time interval $\Delta t$ during the temperature cycle. At a given time, the reliability function input is taken as $\Delta T_1 = max(T1(t)) - T1(tstart)$, i.e. considering that the difference between the maximum temperature measured from the beginning of the cycle and the temperature at the beginning of the cycle is the $\Delta T_1$ for this cycle.

When a local temperature minimum is met, $t_{start}$ is reset and the new value $t_{start}$ is used.

The reference temperature module 100a determines respectively, for each power die D1 and D2, the reference temperatures Tref1 and Tref2 assuming that the ratio between the temperature cycle amplitudes is equal to the ratio between the junction to ambient temperature:

$$\frac{\Delta T_1}{\Delta T_2} = \frac{T_1}{T_2}$$

In other words, the amplitude of the temperature cycles is proportional to the temperature with a certain coefficient:

$$\Delta T_1 = a.\,T_1$$

$$\Delta T_2 = a.\,T_2$$

As an example the parameter a can take the value 0.5.

The reference temperature module 100a determines the reference temperatures Tref1 and Tref2 by balancing the lifetimes of the power dies:

$$R1 = R2$$

$$\alpha_1.\,a^{\beta 1}.\,T_1^{\ \beta 1} = \alpha_2.\,a^{\beta 2}.\,T_2^{\ \beta 2}$$

$$\beta 1.\log(T_1) = \log\left(\frac{\alpha_2.\,a^{\beta 2}}{\alpha_1.\,a^{\beta 1}}\right) + \beta 2.\log(T_2)$$

This relation expresses the relation between log(T1) and log(T2) that leads to a lifetime balancing.

For example, for a measured temperature log(T2), the reference temperature Tref1 is determined by the reference temperature module 100a according to the following equation:

$$\text{Tref1} = a^{-1}.\,\alpha_1^{\ -\frac{1}{\beta 1}}.\,\alpha_2^{\ \frac{1}{\beta 1}}.\,a^{\frac{\beta 2}{\beta 1}}.\,T_2^{\ \frac{\beta 2}{\beta 1}}$$

In this case, the reference temperature Tref2 for the power die D2 can be set (fixed) to be the same value as the measured temperature, this means:

$$\text{Tref}_2 = T_2$$

In the same way, Tref1 can be set (fixed) to be the same value as the measured temperature, and Tref2 can be estimated based on the following equation:

$$\text{Tref2} = a^{-1}.\,\alpha_2^{\ -\frac{1}{\beta 2}}.\,\alpha_1^{\ \frac{1}{\beta 2}}.\,a^{\frac{\beta 1}{\beta 2}}.\,T_1^{\ \frac{\beta 1}{\beta 2}}$$

The decision to fix Tref1 and/or Tref2 according to the measured values T1 and T2 respectively, can be based on any operation criteria. For example, the temperature reference of the most degraded power die can be fixed, and the temperature of the less degraded power die can increase to reach the same degradation level as the most degraded one.

The simple lifetime model including a power function of the temperature cycle amplitude can be enhanced by considering for example the mean temperature value, the heating time and/or the current value ... etc. Such dependencies can be added using the same principle.

The measured temperature T1(t) is subtracted from the reference temperature Tref1 by the subtracting module 124 and the measured temperature T2(t) is subtracted from the reference temperature Tref2 by the subtracting module 122.

The outputs of the subtracting modules 122 and 124 are provided to a gate signal controller 130. The gate signal controller 130 adjusts the duration of the conducting time and/or the switching delay of the power dies D1 and D2 according to the sign of the output of the subtracting modules 122 and 124.

For example, if the output of the subtracting module 122 is positive, the gate control signal 130 increases the duration of the conducting time of the signal SP1 in order to obtain the driving signal g1 and/or increases the switching delay of the driving signal g1 of the power die D1. If the output of the subtracting module 122 is negative or null, the duration of the conduction and/or the switching delay of the signal SP1 is not modified and the driving signal g1 is then equal to the signal SP1. If the output of the subtracting module 124 is positive, the gate control signal 130 increases the duration of the conducting time of the signal SP2 in order to obtain the driving signal g2 and/or increases the switching delay of the driving signal g2 of the power die D2. If the output of the subtracting module 124 is negative or null, the duration of the conduction and/or the switching delay of the signal SP2 is not modified and the driving signal g2 is then equal to the signal SP2.

The increase of duration of the conduction time may be comprised between 10 and 50 microseconds or the delay time may be comprised between 10 or 50 nanoseconds.

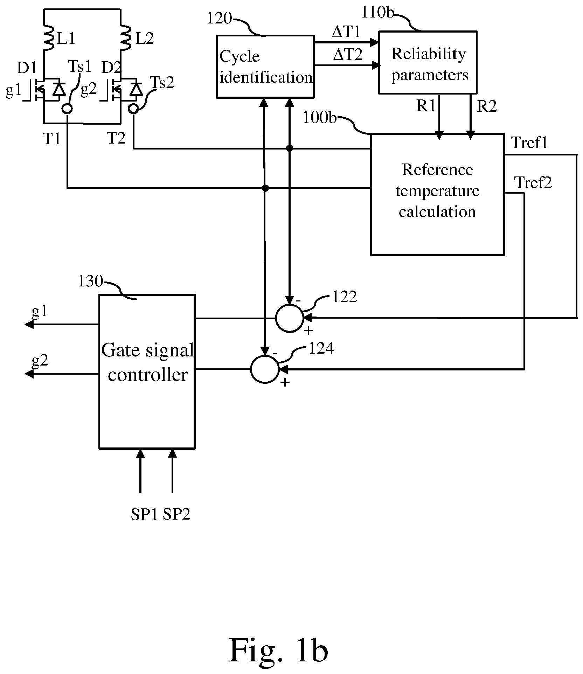

**Fig. 1b** represents a second example of a system for increasing the lifetime of power dies or power modules according to the invention.

In the example of Fig. 1b, the system comprises two power dies D1 and D2 that are connected in parallel.

In Fig. 1b, only two power dies are shown for the sake of clarity. The present invention is also applicable for more than two power dies.

The power dies may be made of different materials such as silicon carbide (SiC) and silicon (Si) and/or of different structures such as metal oxide semiconductor field effect transistor (MOSFET) and insulated gate bipolar transistor (IGBT) and/or of different sizes, such as a 10mm$^2$ area and 100mm$^2$ area and/or of different types of interconnection such as solder and sintered die attach, or such as aluminium and copper wire-bonds.

The power dies may be replaced by power modules, each made of plural power dies in parallel.

In general, the heterogeneous power dies and/or modules present different electro-thermo-mechanical characteristics leading to different fatigue behaviours and reliability performances when connected in parallel.

The inductors L1 and L2 represent load inductors that represent the load of a motor.

For each power die D1, D2, the system comprises temperature sensing means Ts1 and Ts2.

The temperature sensing means Ts1 and Ts2 are temperature sensors located on or near each power die or a thermal sensitive electrical parameter of the power die. For example, the thermal sensitive electrical parameter is an internal gate resistance of the power die.

The temperature sensing means Ts1 provide a temperature value T1(t) of the power die D1. The temperature sensing means Ts2 provide a temperature value T2(t) of the power die D2. The temperature T1(t) and T2(t) are eventually filtered. The temperature values are provided to a reference temperature determination module 100b, to subtracting modules 122 and 124 and to a cycle identification module 120.

The reference temperature module 100b determines respectively, for each power die D1 and D2, a reference temperature Tref1 and Tref2 from the temperature values T1, T2 and from respective reliability parameters R1 and R2.

The reliability parameters are determined by a reliability determination module 110b.

The reliability determination module 110b determines for each power die D1 and D2 the damage parameter R1 and R2 based on a temperature profile consisting in constant temperature swing $\Delta T_1$, $\Delta T_2$, and lifetime models $Nf1$ and $Nf2$ that can be typically expressed as follows:

$$Nf1 = \alpha_1 . \Delta T_1^{\beta_1}$$

$$Nf2 = \alpha_2 . \Delta T_2^{\beta_2}$$

where $\alpha_1$, $\alpha_2$, $\beta_1$ and $\beta_2$ are lifetime model constants that can be determined from power cycling (aging) tests, as they can be fitted on testing data provided by the manufacturer of the power die. As an example, these parameters can take the following values: $\alpha_1 = 1.5 \times 10^{14}$, $\alpha_2 = 2 \times 10^{14}$, $\beta_1 = -6$ and $\beta_2 = -4$.

$\Delta T_1$ and $\Delta T_2$ represent typically the temperature cycle or the temperature variation between maximum and minimum values over an operation or a testing cycle period.

Such lifetime models allow calculating the reliability parameters R1 and R2 which represent a linear damage accumulation (summation) for the power dies D1 and D2, with:

$$R1 = \sum_{i=1}^{i=N} \frac{n_i(\Delta T_1)}{Nf1(\Delta T_1)}$$

$$R2 = \sum_{i=1}^{i=N} \frac{n_i(\Delta T_2)}{Nf2(\Delta T_2)}$$

where $n_i(\Delta T_1)$ and $n_i(\Delta T_2)$ represent the number of cycles at $\Delta T_1$ and $\Delta T_2$ subjected by the power dies D1 and D2 respectively. They can be determined using a stress counting algorithm, for example the Rainflow counter as the one disclosed is the paper of R. GopiReddy, L. M. Tolbert, B. Ozpineci and J. O. P. Pinto, entitled "Rainflow Algorithm-Based Lifetime Estimation of Power Semiconductors in Utility Applications," and published in IEEE Transactions on Industry Applications, vol. 51, no. 4, pp. 3368-3375, July-Aug. 2015, doi: 10.1109/TIA.2015.2407055.

$Nf1(\Delta T_1)$ and $Nf2(\Delta T_2)$ represent the number of cycles to failure at $\Delta T_1$ and $\Delta T_2$ for the power dies D1 and D2 respectively.

In the example of Fig.1b, the reliability parameters represent a damage percentage which increases from 0% at a healthy state to 100% by the end of life or degraded state.

According to a particular feature, the level of damage represented by the reliability parameters R1 and R2 can also be provided by an external condition monitoring apparatus not shown in Fig. 1b which estimates the level of damage of the power dies D1 and D2.

For example, the external condition monitoring apparatus estimates the level of damage based on the monitoring of a failure precursor. The damage may be estimated for example from the evolution of the on-state voltage or the evolution of the thermal resistance or the evolution of the temperatures T1 and T2 for a given operating condition.

It is thus also possible to estimate the level of damage mismatch internally through the knowledge of the temperatures T1 and T2 and of the switching pattern.

The cycle identification module 120 determines from the temperature values T1(t) and T2(t), $\Delta T_1$ and $\Delta T_2$. $\Delta T_1$ and $\Delta T_2$ represent typically the temperature cycle or the temperature variation between maximum and minimum values over an operation or a testing cycle period, i. e.:

$$\Delta T_i = \max\big(T_i(t)\big) - \min\big(T_i(t)\big)$$

with: i=1, 2.

The value of $\min(T_i(t))$ (with: i=1, 2) may represent the start operating temperature, i. e.: $T_i(t_{start})$ (with: i=1, 2) which represents a reference temperature that is generally the coolest point over a cycle period.

The cycle identification module 120 determines the start of a temperature cycle $t_{start}$ for example, using the first derivative of the temperature profile that is evaluated at each discrete time interval $\Delta t$ between two consecutive temperature measurements. A sign change can be used to identify a local temperature minimum, hence the start of a temperature cycle is determined when:

$$\frac{T1(t-\Delta t)-T1(t-2\Delta t)}{\Delta t} < 0 \text{ and } \frac{T1(t)-T1(t-\Delta t)}{\Delta t} > 0 \text{ , then } t_{start} = t - \Delta t$$

When a local temperature minimum is met, $t_{start}$ is reset and the new value $t_{start}$ is used.

The reference temperature module 100b determines respectively, for each power die D1 and D2, the reference temperatures Tref1 and Tref2.

Based on the temperature information $\Delta T1$, $\Delta T2$ and the reliability parameters R1, R2, the reference temperature module 100b determines increments of temperature references. $\Delta Tref1$ and $\Delta Tref2$ can be calculated as follows.

If R1is upper than R2, $\Delta Tref1 = \Delta T1 - \Delta T_{incr}$ and/or $\Delta Tref2 = \Delta T2 + \Delta T_{incr}$.

Otherwise, $\Delta Tref1 = \Delta T1 + \Delta T_{incr}$ and/or $\Delta Tref2 = \Delta T2 - \Delta T_{incr}$.

$\Delta T_{incr}$ represents a temperature increment, that can vary for example in the range of 5°C-50°C dependently on the damage difference R1-R2.

Based on the calculation of the increments of temperature reference $\Delta T_{ref1}$ and $\Delta T_{ref2}$, the reference temperature module 100b determines the reference temperatures as follows:

$$\mathrm{Tref1} \quad = \mathrm{T_{min1}} + \Delta \mathrm{T_{ref1}}$$

$$\mathrm{Tref2} \quad = \mathrm{T_{min2}} + \Delta \mathrm{T_{ref2}}$$

where Tmin 1 and Tmin2 represent the respective minimum temperatures of power dies D1 and D2. Tmin1 and Tmin2 can be ambient or heatsink temperature, for example 20°C or 70°C.

The measured temperature T1(t) is subtracted from the reference temperature Tref1 by the subtracting module 124 and the measured temperature T2(t) is subtracted from the reference temperature Tref2 by the subtracting module 122.

The outputs of the subtracting modules 122 and 124 are provided to a gate signal controller 130. The gate signal controller 130 adjusts the duration of the conducting time and/or the switching delay of the power dies D1 and D2 according to the sign of the output of the subtracting modules 122 and 124 respectively.

For example, if the output of the subtracting module 122 is positive, the gate control signal 130 increases the duration of the conducting time of the signal SP1 in order to obtain the driving signal g1 and/or increases the switching delay of the driving signal g1 of the power die D1. If the output of the subtracting module 122 is negative or null, the duration of the conduction and/or the switching delay of the signal SP1 is not modified and the driving signal g1 is then equal to the signal SP1. If the output of the subtracting module 124 is positive, the gate control signal 130 increases the duration of the conducting time of the signal SP2 in order to obtain the driving signal g2 and/or increases the switching delay of the driving signal g2 of the power die D2. If the output of the subtracting module 124 is negative or null, the duration of the conduction and/or the switching delay of the signal SP2 is not modified and the driving signal g2 is then equal to the signal SP2.

The increase of duration of the conduction time may be comprised between 10 and 50 microseconds or the delay time may be comprised between 10 or 50 nanoseconds.

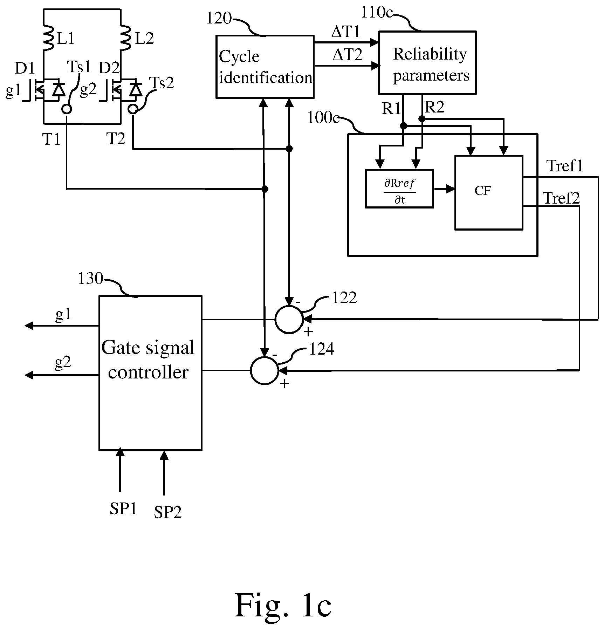

**Fig. 1c** represents a third example of a system for increasing the lifetime of power dies or power modules according to the invention.

In the example of Fig. 1c, the system comprises two power dies D1 and D2 that are connected in parallel.

In Fig. 1c, only two power dies are shown for the sake of clarity. The present invention is also applicable for more than two power dies.

The power dies may be made of different materials such as silicon carbide (SiC) and silicon (Si) and/or of different structures such as metal oxide semiconductor field effect transistor (MOSFET) and insulated gate bipolar transistor (IGBT) and/or of different sizes, such as a 10mm$^2$ area and 100mm$^2$ area and/or of different types of interconnection such as solder and sintered die attach, or such as aluminium and copper wire-bonds.

The power dies may be replaced by power modules, each made of plural power dies in parallel.

In general, the heterogeneous power dies and/or modules present different electro-thermo-mechanical characteristics leading to different fatigue behaviours and reliability performances when connected in parallel.

The inductors L1 and L2 represent load inductors that represent the load of a motor.

For each power die D1, D2, the system comprises temperature sensing means Ts1 and Ts2.

The temperature sensing means Ts1 and Ts2 are temperature sensors located on or near each power die or a thermal sensitive electrical parameter of the power die. For example, the thermal sensitive electrical parameter is an internal gate resistance of the power die.

The temperature sensing means Ts1 provide a temperature value T1(t) of the power die D1. The temperature sensing means Ts2 provide a temperature value T2(t) of the power die D2. The temperature T1(t) and T2(t) are eventually filtered. The temperature values are provided to a reference temperature determination module 100c, to subtracting modules 122 and 124 and to a cycle identification module 120.

The reference temperature module 100c determines respectively, for each power die D1 and D2, a reference temperature Tref1 and Tref2 from the temperature values T1, T2 and from respective reliability parameters R1 and R2.

The reliability parameters are determined by a reliability determination module 110c.

The reliability determination module 110c determines for each power die D1 and D2 the damage parameter R1 and R2 based on a temperature profile consisting in constant temperature swing $\Delta T_1$, $\Delta T_2$, and lifetime models $Nf1$ and $Nf2$ that can be typically expressed as follows:

$$Nf1 = \alpha_1 . \Delta T_1^{\beta_1}$$

$$Nf2 = \alpha_2 . \Delta T_2^{\beta_2}$$

where $\alpha_1$, $\alpha_2$, $\beta_1$ and $\beta_2$ are lifetime model constants that can be determined from power cycling (aging) tests, as they can be fitted on testing data provided by the manufacturer of the power die. As an example, these parameters can take the following values: $\alpha_1 = 1.5 \times 10^{14}$, $\alpha_2 = 2 \times 10^{14}$, $\beta_1$ = -6 and $\beta_2$ = -4.

$\Delta T_1$ and $\Delta T_2$ represent typically the temperature cycle or the temperature variation between maximum and minimum values over an operation or a testing cycle period.

Such lifetime models allow calculating the reliability parameters R1 and R2 which represent a linear damage accumulation (summation) for the power dies D1 and D2, with:

$$R1 = \sum_{i=1}^{i=N} \frac{n_i(\Delta T_1)}{Nf1(\Delta T_1)}$$

$$R2 = \sum_{i=1}^{i=N} \frac{n_i(\Delta T_2)}{Nf2(\Delta T_2)}$$

where $n_i(\Delta T_1)$ and $n_i(\Delta T_2)$ represent the number of cycles at $\Delta T_1$ and $\Delta T_2$ subjected by the power dies D1 and D2 respectively. They can be determined using a stress counting algorithm, for example the Rainflow counter as the one disclosed is the paper of R. GopiReddy, L. M. Tolbert, B. Ozpineci and J. O. P. Pinto, entitled "Rainflow Algorithm-Based Lifetime Estimation of Power Semiconductors in Utility Applications," and published in IEEE Transactions on Industry Applications, vol. 51, no. 4, pp. 3368-3375, July-Aug. 2015, doi: 10.1109/TIA.2015.2407055.

$Nf1(\Delta T_1)$ and $Nf2(\Delta T_2)$ represent the number of cycles to failure at $\Delta T_1$ and $\Delta T_2$ for the power dies D1 and D2 respectively.

In the example of Fig.1c, the reliability parameters represent a damage percentage which increases from 0% at a healthy state to 100% by the end of life or degraded state.

According to a particular feature, the level of damage represented by the reliability parameters R1 and R2 can also be provided by an external condition monitoring apparatus not shown in Fig. 1c which estimates the level of damage of the power dies D1 and D2.

For example, the external condition monitoring apparatus estimates the level of damage based on the monitoring of a failure precursor. The damage may be estimated for example from the evolution of the on-state voltage or the evolution of the thermal resistance or the evolution of the temperatures T1 and T2 for a given operating condition.

It is thus also possible to estimate the level of damage mismatch internally through the knowledge of the temperatures T1 and T2 and of the switching pattern.

The cycle identification module 120 determines from the temperature values T1(t) T2(t), $\Delta T_1$ and $\Delta T_2$ . $\Delta T_1$ and $\Delta T_2$ represent typically the temperature cycle or the temperature variation between maximum and minimum values over an operation or a testing cycle period, i.e.:

$$\Delta T_i = \max\big(T_i(t)\big) - \min\big(T_i(t)\big)$$

with: i=1, 2.

The value of $\min(T_i(t))$ (with: i=1, 2) may represent the start operating temperature, i. e.: $T_i(t_{start})$ (with: i=1, 2) which represents a reference temperature that is generally the coolest point over a cycle period.

The cycle identification module 120 determines the start of a temperature cycle $t_{start}$ for example, using the first derivative of the temperature profile that is evaluated at each discrete time interval $\Delta t$ between two consecutive temperature measurements. A sign change can be used to identify a local temperature minimum. Hence the start of a temperature cycle is determined when:

$$\frac{T1(t-\Delta t)-T1(t-2\Delta t)}{\Delta t} < 0 \text{ and } \frac{T1(t)-T1(t-\Delta t)}{\Delta t} > 0 \text{ , then } t_{start} = t - \Delta t$$

When a local temperature minimum is met, $t_{start}$ is reset and the new value $t_{start}$ is used.

The reference temperature module 100c determines respectively, for each power die D1 and D2, the reference temperatures Tref1 and Tref2.

The reference temperature module 100c determines damage rates using a differential equation:

$$\frac{\partial R1}{\partial t} = \frac{\partial \left(\frac{1}{\alpha_1} \cdot \Delta T_1^{-\beta 1}\right)}{\partial t}$$

$$\frac{\partial R2}{\partial t} = \frac{\partial \left(\frac{1}{\alpha_2} \cdot \Delta T_2^{-\beta 2}\right)}{\partial t}$$

In order to equilibrate the damage change rate of at least two power dies, the cost function is calculated based on the average value of each damage change rate that can be expressed as:

$$\frac{\partial R_{REF}}{\partial t} = \frac{\partial \left(\frac{1}{2 \cdot \alpha_1} \cdot \Delta T_1^{-\beta 1} + \frac{1}{2 \cdot \alpha_2} \cdot \Delta T_2^{-\beta 2}\right)}{\partial t}$$

Here, the reference damage change rate (DCR) for the two power dies is equal, i. e.:

$\frac{\partial R_{REF}}{\partial t} = \frac{\partial R_{REF1}}{\partial t} = \frac{\partial R_{REF2}}{\partial t}$ where $\partial R_{REF1}$ and $\partial R_{REF2}$ are the discretized derivatives of the reference reliability parameters Rref1 and Rref2 respectively according to the time discretization step $\partial t$.

Rref1 and Rref2 are respectively determined by a temporal integration of $\frac{\partial R_{REF1}}{\partial t}$ and $\frac{\partial R_{REF2}}{\partial t}$ .

The reference temperatures are then calculated as follows:

$$CF2 = \min\left[\frac{\partial\left(\frac{1}{\alpha_1}\cdot\Delta T_{ref1}^{-\beta 1}\right)}{\partial t} - \frac{\partial R_{REF}}{\partial t}\right]$$

Find $\Delta T_{ref1}$ with a cost function

As we can solve the following integration:

$$\int \frac{\partial R_{REF}}{\partial t} \cdot \partial t + R1^{initial} = \frac{1}{\alpha_1} \cdot \Delta T_{ref1}^{-\beta 1}$$

$$\log\left(\alpha_1 \cdot \left(\int \frac{\partial R_{REF}}{\partial t} \cdot \partial t + R1^{initial}\right)\right) = -\beta 1 \cdot \log(\Delta T_{ref1})$$

$$\log(\Delta T_{ref1}) = \frac{\log\left(\alpha_1 \cdot \left(\int \frac{\partial R_{REF}}{\partial t} \cdot \partial t + R1^{initial}\right)\right)}{-\beta 1}$$

$$\Delta T_{ref1} = \exp\left(\alpha_1 \cdot \left(\int \frac{\partial R_{REF}}{\partial t} \cdot \partial t + R1^{initial}\right)\right)^{-1/\beta 1}$$

$R1^{initial}$ represents the initial damage in the power die D1 that is typically equal to zero. Using the same calculation, we can determine the value of $\Delta T_{ref2}$.

Based on the calculation of $\Delta T_{ref1}$ and $\Delta T_{ref2}$, the reference temperatures can be expressed as follows:

$$Tref1 = T_{min1} + \Delta T_{ref1}$$

$$Tref2 = T_{min2} + \Delta T_{ref2}$$

Tmin1 and Tmin2 represents the minimum temperatures of the power dies D1 and D2 respectively. They can be ambient or heatsink temperature, for example 20°C or 70°C.

The damage rate can be calculated also using discrete values of time; thus, the derivatives are replaced by division and the integrals by multiplications. The time intervals may be 100 hours for example.

The measured temperature T1(t) is subtracted from the reference temperature Tref1 by the subtracting module 124 and the measured temperature T2(t) is subtracted from the reference temperature Tref2 by the subtracting module 122.

The outputs of the subtracting modules 122 and 124 are provided to a gate signal controller 130. The gate signal controller 130 adjusts the duration of the conducting time and/or the switching delay of the power dies D1 and D2 according to the sign of the output of the subtracting modules 122 and 124.

For example, if the output of the subtracting module 122 is positive, the gate control signal 130 increases the duration of the conducting time of the signal SP1 in order to obtain the driving signal g1 and/or increases the switching delay of the driving signal g1 of the power die D1. If the output of the subtracting module 122 is negative or null, the duration of the conduction and/or the switching delay of the signal SP1 is not modified and the driving signal g1 is then equal to the signal SP1. If the output of the subtracting module 124 is positive, the gate control signal 130 increases the duration of the conducting time of the signal SP2 in order to obtain the driving signal g2 and/or increases the switching delay of the driving signal g2 of the power die D2. If the output of the subtracting module 124 is negative or null, the duration of the conduction and/or the switching delay of the signal SP2 is not modified and the driving signal g2 is then equal to the signal SP2.

The increase of duration of the conduction time may be comprised between 10 and 50 microseconds or the delay time may be comprised between 10 or 50 nanoseconds.

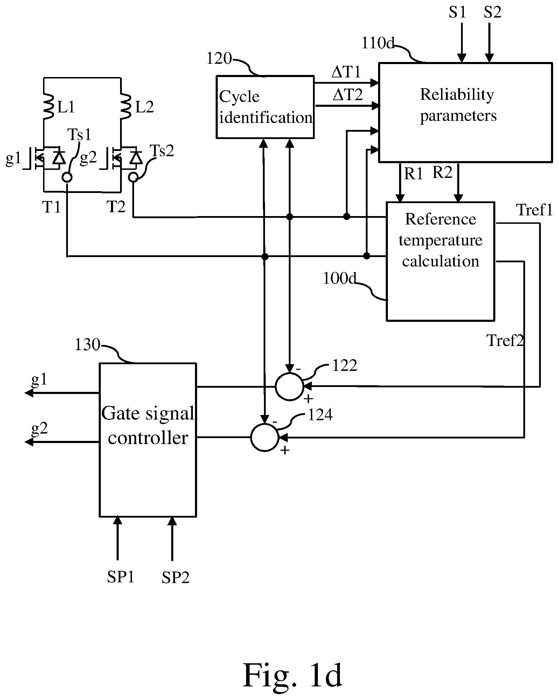

**Fig. 1d** represents a fourth example of a system for increasing the lifetime of power dies or power modules according to the invention.

In the example of Fig. 1d, the system comprises two power dies D1 and D2 that are connected in parallel.

In Fig. 1d, only two power dies are shown for the sake of clarity. The present invention is also applicable for more than two power dies.

The power dies may be made of different materials such as silicon carbide (SiC) and silicon (Si) and/or of different structures such as metal oxide semiconductor field effect transistor (MOSFET) and insulated gate bipolar transistor (IGBT) and/or of different sizes, such as a $10mm^2$ area and $100mm^2$ area and/or of different types of interconnection such as solder and sintered die attach, or such as aluminium and copper wire-bonds.

The power dies may be replaced by power modules, each made of plural power dies in parallel.

In general, the heterogeneous power dies and/or modules present different electro-thermo-mechanical characteristics leading to different fatigue behaviours and reliability performances when connected in parallel.

The inductors L1 and L2 represent load inductors that represent the load of a motor.

For each power die D1, D2, the system comprises temperature sensing means Ts1 and Ts2.

The temperature sensing means Ts1 and Ts2 are temperature sensors located on or near each power die or a thermal sensitive electrical parameter of the power die. For example, the thermal sensitive electrical parameter is an internal gate resistance of the power die.

The temperature sensing means Ts1 provide a temperature value T1(t) of the power die D1. The temperature sensing means Ts2 provide a temperature value T2(t) of the power die D2. The temperature T1(t) and T2(t) are eventually filtered. The temperature values are provided to a reference temperature determination module 100d, to subtracting modules 122 and 124 and to a cycle identification module 120.

The reference temperature module 100d determines respectively, for each power die D1 and D2, a reference temperature Tref1 and Tref2 from the temperature values T1, T2 and from respective reliability parameters R1 and R2.

The reliability parameters are determined by a reliability determination module 110d.

The reliability determination module 110d determines the temperature history as histograms of temperature cycles, e.g. representing the number of times various temperature cycles were observed. The reduction of a spectrum of varying temperature cycles into an equivalent set of simple temperature cycles may be done by stress counting algorithms such as the rainflow algorithm.

The reliability determination module 110d determines a state of health that is for example obtained from at least one value representing the crack length of at least one interconnection. For example, Sj is a crack length in a wire-bond or Sij='$a_{ij}$' a crack length array with values for each wire-bond i of the power die Dj, or Sj='$a_{eq\,j}$', and equivalent crack length for the power die Dj, or Sj=$\Delta$Relec j , the electrical resistance increase due to crack propagation for the power die Dj.

The reliability parameters R1 and R2 are calculated from *a priori* knowledge of a lifetime model. It is a law taking the power dies temperature histories and the state of health variables S1, S2 as input parameters and calculating the lifetime as the output. In the simplest case, assuming a temperature profile consisting in constant temperature swing $\Delta$T1, $\Delta$T2, an example of such a law is:

$$R1 = f(\Delta T_1, \gamma_1, \delta 1, S1)$$

$$R2 = f(\Delta T_2, \gamma_2, \delta 2, S2)$$

Hence the model calibration is done during the system life.

One example is the Paris Law, where we can write for the power die D1 under variable temperature profile:

$$\sum_{i=1}^{i=N0} \frac{da_{1i}}{dN_i} = \sum_{i=1}^{i=N0} \gamma_1 . \Delta T1_i{}^{\delta_1}$$

*N*0 represents a given number of cycles, for example N0=1000 cycles, $\dfrac{da_{1i}}{dN_i}$ represents the *i th* crack length derivative with regard to the number of cycles, $\Delta T1_i$ represents the *i th* temperature cycle in the power die D1. In the previous example, the stress parameter is equivalent to the temperature cycle $\Delta T1_i$. However, in general the stress parameter can have a different physical meaning and a different expression that may be a function of the temperature cycle $\Delta T1_i$. This case will be described in the following.

With this example of equation, two iterations at two different N0 values, for example at N0=1000 cycles and N0=5000 cycles, permit the identification of $\gamma_1$ and $\delta_1$ which constitute R1. $\gamma_1$ and $\delta_1$ can take the values for example 2 $\times$ 10^6 and -4 respectively.

More specifically, in a basic case of two power dies, with corresponding interconnection crack length $a_1$ and $a_2$ the lifetime model can be expressed using a Paris Law as follows:

$$\frac{da_1}{dN} = \gamma_1' . \Delta G_1{}^{\delta_1'}$$

$$\frac{da_2}{dN} = \gamma_2' . \Delta G_2{}^{\delta_2'}$$

where $\Delta G_1$ and $\Delta G_2$ characterize the stress intensity for the power dies D1 and D2 respectively. They can be for example be equal to 0.5 J/m2, and $\gamma_1'$, $\gamma_2'$, $\delta_1$, $\delta_2'$ are the Paris model constants; for example, they can have the following values: 3 $\times$ 10^6, 3.5 $\times$ 10^5, -5, -7, respectively. In general $\Delta G_1$ and $\Delta G_2$ can be expressed as:

$$\Delta G_1 = f_1(\Delta T_1, a_1) \ \& \ \Delta G_2 = f_2(\Delta T_2, a_2)$$

For example, in the simplest analytical form, $\Delta G_1$ and $\Delta G_2$ are proportional to $(l_0 - a_1) . \Delta T_1^2$ and $(l_0 - a_2) . \Delta T_2^2$, respectively, where $l_0$ is a geometrical factor related to the initial bond length, for example it can be equal to 800 micrometers. $a_1$ and $a_2$ represent the crack lengths and they change between 0 and $l_0$. More exact relationships between $\Delta G_i$ and $\Delta T_i$ may be calculated for the specific geometries, material properties and material constitutive laws by finite element analysis, for example, using simulation software ANSYS or COMSOL Multiphysics. Hence equation becomes:

$$\frac{da_1}{dN} = \gamma_1 . [(l_0 - a_1) . \Delta T_1^2]^{\delta_1}$$

Here, $\Delta T_1$ and $\Delta T_2$ represent typically the temperature cycle or the temperature variation between maximum and minimum values over an operation or a testing cycle period, dN is a discretization step in view of N.

Further to give an explicit relation between R1, the temperature history and the model variables, the reliability function can be calculated by integration of dN over the change of crack length from a value $a_{1,0}$ to a value $a_{1,1}$. In case $\delta 1 = 1$, as is generally observed in fracture mechanics, integration of dN in the previous equation between $l_0 - a_{1,0}$ and $l_0 - a_{1,1}$ gives:

$$N1 = R1 = \frac{\ln(l_0 - a_{1,0}) - \ln(l_0 - a_{1,1})}{\gamma_1 \Delta T_1^2}$$

$$N2 = R2 = \frac{\ln(l_0 - a_{2,0}) - \ln(l_0 - a_{2,1})}{\gamma_2 \Delta T_2^2}$$

Or more generally if $\delta 1 \neq 1$:

$$N1 = R1 = \frac{(l_0 - a_{1,0})^{1-\delta_1} - (l_0 - a_{1,1})^{1-\delta_1}}{(1-\delta_1) \gamma_1 \Delta T_i^{2\delta_1}}$$

The measurement of two values of $a_1$ ($a_{1,0}$, $a_{1,1}$) at two different number of cycles permits the estimation of $\gamma_1$ and $\delta 1$. This mode of implementation can be performed on-line or off-line. In the case of an off-line implementation, the values of the state of health S 1 and S2 can be estimated at high precision a low number of times, for example one to five times, for example during a maintenance routine. In case of an on-line implementation, the value of the state of health S 1 and S2 are estimated from the measurement of parameter measurable on-line, for example the on-state resistance increase $\Delta$Relec 1, $\Delta$Relec 2. In this case, an equivalent crack length in power die D1 noted by $aeq_1$ may be calculated using the following equation:

$$\Delta\text{Relec } 1 = \varepsilon_1 \frac{1}{(l_0 - aeq_1)}$$

where $\varepsilon_1$ is a constant that depends on the geometry and material properties, $l_0$ is a geometrical factor related to the initial bond length.

Advantageously, such on-line implementation enables more frequent evaluation of the model parameters $\gamma_1$, $\delta 1$ and the increase of the reliability model precision during the system life as discussed previously.

The cycle identification module 120 determines from the temperature values T1(t) T2(t), $\Delta T_1$ and $\Delta T_2$ . $\Delta T_1$ and $\Delta T_2$ represent typically the temperature cycle or the temperature variation between maximum and minimum values over an operation or a testing cycle period, i. e.:

$$\Delta T_i = \max(T_i(t)) - \min(T_i(t))$$

with: i=1, 2.

The value of $\min(T_i(t))$ (with: i=1, 2) may represent the start operating temperature, i. e.: $T_i(t_{start})$ (with: i=1, 2) which represents a reference temperature that is generally the coolest point over a cycle period.

The cycle identification module 120 determines the start of a temperature cycle $t_{start}$ for example, using the first derivative of the temperature profile that is evaluated at each discrete time interval $\Delta t$ between two consecutive temperature measurements. A sign change can be used to identify a local temperature minimum, hence the start of a temperature cycle is determined when:

$$\frac{T1(t-\Delta t)-T1(t-2\Delta t)}{\Delta t} < 0 \text{ and } \frac{T1(t)-T1(t-\Delta t)}{\Delta t} > 0 \text{ , then } t_{start} = t - \Delta t$$

When a local temperature minimum is met, $t_{start}$ is reset and the new value $t_{start}$ is used.

The reference temperature module 100d determines respectively, for each power die D1 and D2, the reference temperatures Tref1 and Tref2.

The reference temperatures Tref1 and Tref2 are determined in order to equalize the degradation as soon as possible making sure one die is not over-heating above the safe operating area, or after a certain time or at the end of life.

The reference temperature module 100b determines respectively, for each power die D1 and D2, the reference temperatures Tref1 and Tref2.

Based on the temperature information $\Delta T1$, $\Delta T2$ and the reliability parameters R1, R2, the reference temperature module 100d determines increments of temperature references. $\Delta Tref1$ and $\Delta Tref2$ can be calculated as follows:

If R1is upper than R2, $\Delta Tref1=\Delta T1-\Delta T_{incr}$ and/or $\Delta Tref2=\Delta T2+\Delta T_{incr}$.

Otherwise, $\Delta Tref1=\Delta T1+\Delta T_{incr}$ and/or $\Delta Tref2=\Delta T2-\Delta T_{incr}$.

$\Delta T_{incr}$ represents a temperature increment, that can vary for example in the range of 5°C-50°C dependently on the damage difference R1-R2.

Based on the calculation of the increments of temperature reference $\Delta T_{ref1}$ and $\Delta T_{ref2}$, the reference temperature module 100b determines the reference temperatures as follow:

$$\text{Tref1} \quad = \text{T}_{min1} + \Delta \text{T}_{ref1}$$

$$\text{Tref2} \quad = \text{T}_{min2} + \Delta \text{T}_{ref2}$$

where Tmin 1 and Tmin2 represent the respective minimum temperatures of power dies D1 and D2. Tmin1 and Tmin2 can be ambient or heatsink temperature, for example 20°C or 70°C.

The measured temperature T1(t) is subtracted from the reference temperature Tref1 by the subtracting module 124 and the measured temperature T2(t) is subtracted from the reference temperature Tref2 by the subtracting module 122.

The outputs of the subtracting modules 122 and 124 are provided to a gate signal controller 130. The gate signal controller 130 adjusts the duration of the conducting time and/or the switching delay of the power dies D1 and D2 according to the sign of the output of the subtracting modules 122 and 124.

For example, if the output of the subtracting module 122 is positive, the gate control signal 130 increases the duration of the conducting time of the signal SP1 in order to obtain the driving signal g1 and/or increases the switching delay of the driving signal g1 of the power die D1. If the output of the subtracting module 122 is negative or null, the duration of the conduction and/or the switching delay of the signal SP1 is not modified and the driving signal g1 is then equal to the signal SP1. If the output of the subtracting module 124 is positive, the gate control signal 130 increases the duration of the conducting time of the signal SP2 in order to obtain the driving signal g2 and/or increases the switching delay of the driving signal g2 of the power die D2. If the output of the subtracting module 124 is negative or null, the duration of the conduction and/or the switching delay of the signal SP2 is not modified and the driving signal g2 is then equal to the signal SP2.

The increase of duration of the conduction time may be comprised between 10 and 50 microseconds or the delay time may be comprised between 10 or 50 nanoseconds.

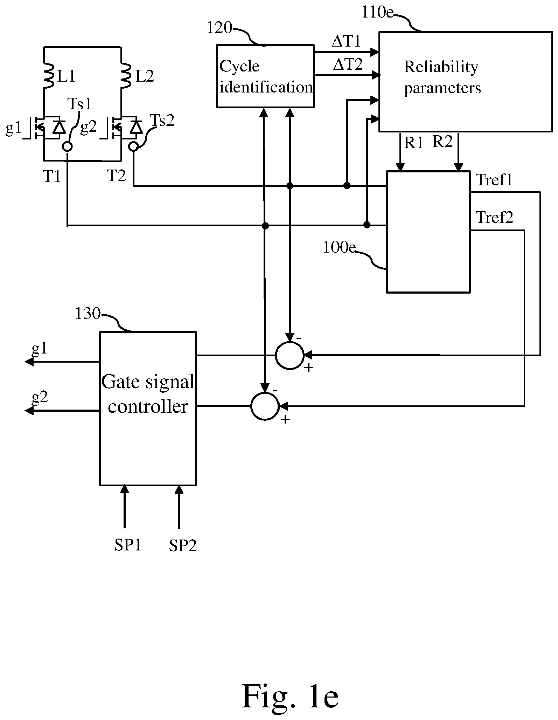

**Fig. 1e** represents a fifth example of a system for increasing the lifetime of power dies or power modules according to the invention.

In the example of Fig. 1e, the system comprises two power dies D1 and D2 that are connected in parallel.

In Fig. 1e, only two power dies are shown for the sake of clarity. The present invention is also applicable for more than two power dies.

The power dies may be made of different materials such as silicon carbide (SiC) and silicon (Si) and/or of different structures such as metal oxide semiconductor field effect transistor (MOSFET) and insulated gate bipolar transistor (IGBT) and/or of different sizes, such as a 10mm$^2$ area and 100mm$^2$ area and/or of different types of interconnection such as solder and sintered die attach, or such as aluminium and copper wire-bonds.

The power dies may be replaced by power modules, each made of plural power dies in parallel.

In general, the heterogeneous power dies and/or modules present different electro-thermo-mechanical characteristics leading to different fatigue behaviours and reliability performances when connected in parallel.

The inductors L1 and L2 represent load inductors that represent the load of a motor.

For each power die D1, D2, the system comprises temperature sensing means Ts1 and Ts2.

The temperature sensing means Ts1 and Ts2 are temperature sensors located on or near each power die or a thermal sensitive electrical parameter of the power die. For example, the thermal sensitive electrical parameter is an internal gate resistance of the power die.

The temperature sensing means Ts1 provide a temperature value T1(t) of the power die D1. The temperature sensing mean Ts2 provides a temperature value T2(t) of the power die D2. The temperature T1(t) and T2(t) are eventually filtered. The temperature values are provided to a reference temperature determination module 100e, to subtracting modules 122 and 124 and to a cycle identification module 120.

The reference temperature module 100e determines respectively, for each power die D1 and D2, a reference temperature Tref1 and Tref2 from the temperature values T1, T2 and from respective reliability parameters R1 and R2.

The reliability parameters are determined by a reliability determination module 110e. The reliability determination module 110e may be identical to the reliability determination module 110a, 110b, 110c or 110d.

Once the reliability parameters R1 and R2 are known, the future degradation rate may be estimated by the reference temperature module 100e as a function of the reference temperatures. Given the unknown nature of the future temperature profiles, distribution rules for the reference temperatures of the parallel dies are required. Temperature distribution rules may take different forms, for example reference temperature ratios K1 and K2 may be defined as dependent of the reference temperatures. For example:

$$K1 = Tref1 / Tref2$$

$$K2 = Tref2 / Tref2$$

By knowledge of the reliability parameters R1 and R2, the reference temperature ratios K1 and K2 are calculated such as the state of health variable for each power die D1, D2 will reach respective critical failure value $D_{fi}$ at the same time. For example, the critical failure value for the die Di with i=1 to 2 may be that the crack length of at least one interconnection has reached a predetermined value $a_{fi}$.

Thus advantageously, all the power dies fail at the same time and the overall system life is maximized.

The damage per power die D1 and D2 represents the crack length or a value normalized to the initial wire contact length.

The aim of the fifth example of implementation is to optimize the system lifetime extension, so that the reference temperatures are calculated with the target to reach the failure criteria of the power dies at the same time.

In a basic case of two power dies D1 and D2, the lifetime model can be expressed using a Paris Law as follows:

$$\frac{da_1}{dN} = \gamma_1 . \Delta K_1{}^{\delta_1}$$

$$\frac{da_2}{dN} = \gamma_2 . \Delta K_2{}^{\delta_2}$$

where $\Delta K_1$ and $\Delta K_2$ are the stress intensity factors for the power dies D1 and D2 respectively before the application of the proposed lifetime/damage balancing technique, i.e. $N \leq N1$, where:

$$\Delta K_1 = f_1(\Delta T_1) \ \& \ \Delta K_2 = f_2(\Delta T_2)$$

$\Delta K_1$ and $\Delta K_2$ can be for example equal to 2 $MPa.\sqrt{m}$. $a_1$ and $a_2$ represent the crack length evolution as a function of the number of cycles for the power dies D1 and D2 respectively. $\gamma_1, \gamma_2, \delta_1, \delta_2$ are the Paris model constants;

for example they can have the following values: $3 \times 10^6$, $3.5 \times 10^5$, -5, -7, respectively. N1 represents a given number of cycles (for example equal to 2000 cycles) after which the proposed lifetime/damage technique starts to be applied. $\Delta K_1$ and $\Delta K_2$ can be determined for example by numerical simulation using ANSYS or COMSOL Multiphysics under different temperature cycles and different crack lengths. For example they can be expressed typically analytically as follows:

$$\Delta K_1 = x_1 . \Delta T_1^{x_2} . \left( a_{1,0} - a_1 \right)^{x_3}$$

$$\Delta K_2 = x_1' . \Delta T_2^{x_2'} . \left( a_{2,0} - a_2 \right)^{x_3'}$$

where $x_1$, $x_1'$, $x_2$, $x_2'$, $x_3$ and $x_3'$ are constants that can take respectively the following value: 2, 2.5, 3, 3.5, 1 and 1.5. $a_{1,0}$ and $a_{2,0}$ are geometrical factors related to the initial bond length for the power dies D1 and D2 respectively. For example they can be equal to 800 micrometers.

Moreover, $\Delta T_1$ and $\Delta T_2$ represent typically the temperature cycle or the temperature variation between maximum and minimum values over an operation or a testing cycle period. The temperature cycles are determined by the cycle identification module 120 as described previously.

In order to reach simultaneously the end of life for the power dies D1 and D2, the stress intensity factors of both devices $\Delta K_{ref1}$ and $\Delta K_{ref2}$ can be calculated based on the solution of the following two main equations:

1.

$$a_2(N_1) - a_1(N_1) = \int_{N_1}^{N_f} \gamma_1 . \Delta K_{ref1}^{\delta_1} dN - \int_{N_2}^{N_f} \gamma_2 . \Delta K_{ref2}^{\delta_2} dN$$

2.

$$N_f - N_1 = \int_{a_1(N_1)}^{a_f} \frac{da_1}{\gamma_1 . \Delta K_{ref1}^{\delta_1}} = \int_{a_2(N_1)}^{a_f} \frac{da_2}{\gamma_2 . \Delta K_{ref2}^{\delta_2}}$$

where N1 represents a given number of cycles after which the proposed technique starts to be applied. N1 may be selected between 1 and Nf which represents the number of cycles to failure of the power dies D1 and/or D2. It must be noted that the previous two equations give an infinity number of solutions since there are three variables: $\Delta K_{ref1}$, $\Delta K_{ref2}$ and $N_f$. However, there is a third equation imposed by the load conditions (example: constant load current, constant load power ... etc.) or by the switching limits. Otherwise, the equations are solved considering the following cost function:

$$CF4 = \max(N_f)$$

In order to calculate $\Delta T_{ref1}$ and $\Delta T_{ref1}$ based on $\Delta K_{ref1}$ and $\Delta K_{ref2}$, the reciprocal functions of the stress intensity expressions are used:

$$\Delta T_{ref1} = f_1^{-1}(\Delta K_{ref1}) = \sqrt[x_2]{\frac{\Delta K_{ref1}}{x_1 . \left( a_{1,0} - a_1 \right)^{x_3}}}$$

$$\Delta T_{ref2} = f_2^{-1}(\Delta K_{ref2}) = \sqrt[x_2']{\frac{\Delta K_{ref2}}{x_1' . \left( a_{2,0} - a_2 \right)^{x_3'}}}$$

Finally, Tref1 and Tref2 can be evaluated based on the previous two equations, with:

$$T_{ref1} = T_{min1} + \Delta T_{ref1}$$

$$T_{ref2} = T_{min2} + \Delta T_{ref2}$$

Based on the calculation of $\Delta T_{ref1}$ and $\Delta T_{ref2}$, the reference temperatures can be expressed as follows:

$$T_{ref1} = T_{min1} + \Delta T_{ref1}$$

$$T_{ref2} = T_{min2} + \Delta T_{ref2}$$

Tmin1 and Tmin2 represent the minimum temperatures of devices D1 and D2 respectively. They can be ambient or heatsink temperature, for example 20°C or 70°C.
The measured temperature T1(t) is subtracted from the reference temperature Tref1 by the subtracting module 124 and the measured temperature T2(t) is subtracted from the reference temperature Tref2 by the subtracting module 122.
The outputs of the subtracting modules 122 and 124 are provided to a gate signal controller 130. The gate signal controller 130 adjusts the duration of the conducting time and/or the switching delay of the power dies D1 and D2 according to the sign of the output of the subtracting modules 122 and 124.
For example, if the output of the subtracting module 122 is positive, the gate control signal 130 increases the duration of the conducting time of the signal SP1 in order to obtain the driving signal g1 and/or increases the switching delay of the driving signal g1 of the power die D1. If the output of the subtracting module 122 is negative or null, the duration of the conduction and/or the switching delay of the signal SP1 is not modified and the driving signal g1 is then equal to the signal SP1. If the output of the subtracting module 124 is positive, the gate control signal 130 increases the duration of the conducting time of the signal SP2 in order to obtain the driving signal g2 and/or increases the switching delay of the driving signal g2 of the power die D2. If the output of the subtracting module 124 is negative or null, the duration of the conduction and/or the switching delay of the signal SP2 is not modified and the driving signal g2 is then equal to the signal SP2.
The increase of duration of the conduction time may be comprised between 10 and 50 microseconds or the delay time may be comprised between 10 or 50 nanoseconds.

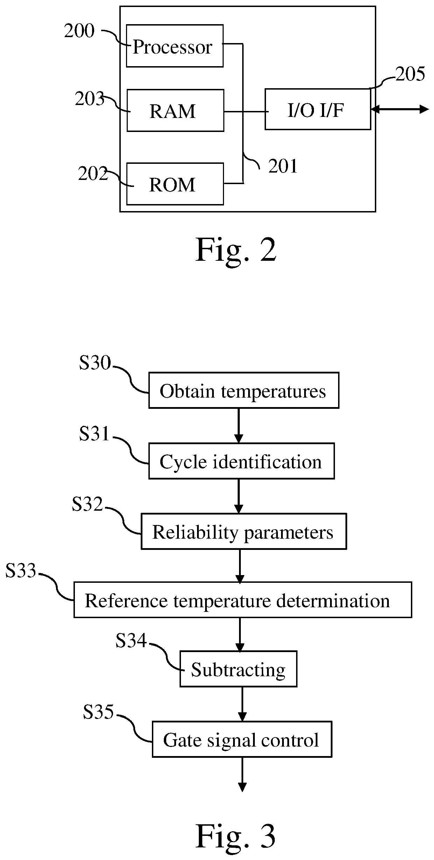

Fig. 2 represents a sixth example of a system for increasing the lifetime of power dies or power modules according to the invention.
The system has, for example, an architecture based on components connected together by a bus 201 and a processor 200 controlled by a program as disclosed in Fig. 3.
The bus 201 links the processor 200 to a read only memory ROM 202, a random access memory RAM 203 and an input output I/O IF interface 205.
The memory 203 contains registers intended to receive variables and the instructions of the program related to the algorithm as disclosed in Fig. 3.
The read-only memory, or possibly a Flash memory 202, contains instructions of the programs related to the algorithm as disclosed in Fig. 3, when the system is powered on, are loaded to the random access memory 203. Alternatively, the program may also be executed directly from the ROM memory 202.
The control performed by the system may be implemented in software by execution of a set of instructions or program by a programmable computing machine, such as a PC (*Personal Computer*), a DSP (*Digital Signal Processor*) or a microcontroller; or else implemented in hardware by a machine or a dedicated component, such as an FPGA (*Field-Programmable Gate Array*) or an ASIC (*Application-Specific Integrated Circuit*).
In other words, the system includes circuitry, or a device including circuitry, causing the system to perform the program related to the algorithm as disclosed in Fig. 3.
Fig. 3 represents an example of an algorithm executed according to the present invention.
The present algorithm is disclosed in an example wherein it is executed by the processor 200.
At step S30, the processor 200 obtains the temperature of the power dies or the power modules.
At step S31, the processor 200 identifies, for each power die or power module, temperature cycles from the sensed temperatures.
At step S32, the processor 200 determines, for each power die or power module, reliability parameters from the identified temperature cycles.
At step S33, the processor 200 determining, for each power die or power module, reference temperatures.

At step S34, the processor 200 subtracts, for each power die or power module, the sensed temperature of the power die or power module from the determined reference temperature of the power die or power module.

At step S35, the processor 200 adjusts the duration of the conducting time and/or the switching delay of the power dies or the power modules according to the sign of the output of the subtracting.

Naturally, many modifications can be made to the embodiments of the invention described above without departing from the scope of the present invention, which is defined by the appended claims.

**Claims**

1. A method for increasing the lifetime of at least two power dies or power modules, wherein the method comprises the steps of:

   - sensing the temperature of the power dies or the power modules,
   - identifying, for each power die or power module, temperature cycles from the sensed temperatures,
   - determining, for each power die or power module, reliability parameters from the identified temperature cycles,
   - determining, for each power die or power module, reference temperatures, using the reliability parameters,
   - subtracting, for each power die or power module, the sensed temperature of the power die or power module from the determined reference temperature of the power die or power module,
   - adjusting the duration of the conducting time and/or the switching delay of at least one power die or power module according to the sign of the output of the subtracting step.

2. The method according to claim 1, **characterized in that**, for each power die or power module, the temperature cycle is equal to the temperature difference between the last sensed local maximum temperature and an initial temperature that is determined as a last local minimum temperature.

3. The method according to claim 1 or 2, **characterized in that** the reliability parameters R1 and R2 are determined as:

$$R1 = \alpha_1 . \Delta T_1^{/}$$

$$R2 = \alpha_2 . \Delta T_2^{\beta_2}$$

where $\alpha_1$, $\alpha_2$, $\beta_1$ and $\beta_2$ are reliability constants that can be determined from power cycling tests and fitted on testing data provided by the manufacturer of the power dies or power modules, $\Delta T_1$ and $\Delta T_2$ are the respective temperature cycles of the power dies or power modules.

4. The method according to claim 3, **characterized in that** the reference temperature of one power die or power module is determined assuming that a ratio between the temperature cycle amplitudes is equal to the ratio between the junction temperature of the power dies or power modules to ambient temperature and by equalizing the reliability parameters of the power dies or power modules.

5. The method according to claim 1 or 2, **characterized in that** the reliability parameters are determined from lifetime models *Nf*1 and *Nf*2 that can be expressed as:

$$Nf1 = \alpha_1 . \Delta T_1^{\beta_1}$$

$$Nf2 = \alpha_2 . \Delta T_2^{\beta_2}$$

where $\alpha_1$, $\alpha_2$, $\beta_1$ and $\beta_2$ are reliability constants that can be determined from power cycling tests and fitted on testing data provided by the manufacturer of the power dies or power modules, $\Delta T_1$ and $\Delta T_2$ are the respective temperature cycles of the power dies or power modules and the reliability parameters R1 and R2 are determined as:

$$R1 = \sum_{i=1}^{i=N} \frac{n_i(\Delta T_1)}{Nf1(\Delta T_1)}$$

$$R2 = \sum_{i=1}^{i=N} \frac{n_i(\Delta T_2)}{Nf2(\Delta T_2)}$$

where $n_i(\Delta T_1)$ and $n_i(\Delta T_2)$ represent the number of cycles at $\Delta T_1$ and $\Delta T_2$.

6. The method according to claim 5, **characterized in that** the reference temperature of each power die or power module is determined by increasing or decreasing the temperature cycle of the power die or power module by an increment according to a comparison of the reliability and by summing the increased or decreased temperature cycle to a predetermined temperature.

7. The method according to claim 5, **characterized in that** the reference temperature of each power die or power module is determined by a calculated damage change rate of the reliability parameter of the power die or power module, and by equilibrating the damage change rates, the damage change rates being calculated as:

$$\frac{\partial R1}{\partial t} = \frac{\partial \left( \frac{1}{\alpha_1} \cdot \Delta T_1^{-\beta 1} \right)}{\partial t}$$

$$\frac{\partial R2}{\partial t} = \frac{\partial \left( \frac{1}{\alpha_2} \cdot \Delta T_2^{-\beta 2} \right)}{\partial t}$$

and by determining, for each power die or power module, an increment of temperature that minimises the difference between the damage change rate of the power die or power module and the average value of the damage change rates and by summing the increment of temperature of the power die or power module to a predetermined temperature.

8. The method according to claim 1 or 2, **characterized in that** the reliability parameters are determined from *a priori* knowledge of a lifetime model as:

$$R1 = \frac{\ln\left(l_0 - a_{1,0}\right) - \ln\left(l_0 - a_{1,1}\right)}{\gamma_1 \Delta T_1^{2}}$$

$$R2 = \frac{\ln\left(l_0 - a_{2,0}\right) - \ln\left(l_0 - a_{2,1}\right)}{\gamma_2 \Delta T_2^{2}}$$

where $\gamma_1$ and $\gamma_2$ are determined from two different numbers of temperature cycles, $a_{1,0}$ and $a_{1,1}$ represent a length value change of a crack of a connection of a first power die, $a_{2,0}$ and $a_{2,1}$ represent a length value change of a crack of a connection of a second power die, $\Delta T_1$ is the temperature cycle of the first power die or power module and $\Delta T_2$ is the temeprature cycle of the second power die or power module.

9. The method according to claim 8, **characterized in that** the reference temperature of each power die or power module is determined by increasing or decreasing the temperature cycle of the power die or power module by an increment according to a comparison of the reliability and by summing the increased or decreased temperature cycle to a predetermined temperature.

10. The method according to claim 1 or 2, **characterized in that** the reliability parameters are determined from *a priori* knowledge of a lifetime model as:

$$\frac{da_1}{dN} = \gamma_1 . \Delta K_1{}^{\delta_1}$$

$$\frac{da_2}{dN} = \gamma_2 . \Delta K_2{}^{\delta_2}$$

where $\Delta K_1$ and $\Delta K_2$ are the stress intensity factors for the power dies that are function of the temperature cycles $\Delta T_1$ and $\Delta T_2$ respectively, and wherein an optimization is used in order to extend the system lifetime, so that the reference temperatures are calculated with the target to reach the failure criteria of the power dies at the same time using stress intensity factors of both power dies $\Delta K_{ref1}$ and $\Delta K_{ref2}$ calculated based on the solution of the following two main equations:

$$a_2(N_1) - a_1(N_1) = \int_{N_1}^{N_f} \gamma_1 . \Delta K_{ref1}{}^{\delta_1} dN - \int_{N_2}^{N_f} \gamma_2 . \Delta K_{ref2}{}^{\delta_2} dN$$

$$N_f - N_1 = \int_{a_1(N_1)}^{a_f} \frac{da_1}{\gamma_1 . \Delta K_{ref1}{}^{\delta_1}} = \int_{a_2(N_1)}^{a_f} \frac{da_2}{\gamma_2 . \Delta K_{ref2}{}^{\delta_2}}$$

where N1 represents a given number of cycles prior the system lifetime extension, N1 being selected between 1 and Nf which represents the number of cycles to failure of the power dies.

11. A system for increasing the lifetime of at least two power dies or power modules, wherein the system comprises:

- means for sensing the temperature of the power dies or the power modules,
- means for identifying, for each power die or power module, temperature cycles from the sensed temperatures,
- means for determining, for each power die or power module, reliability parameters from the identified temperature cycles,
- means for determining, for each power die or power module, reference temperatures, using the reliability parameters,
- means for subtracting, for each power die or power module, the sensed temperature of the power die or power module from the determined reference temperature of the power die or power module,
- means for adjusting the duration of the conducting time and/or the switching delay of at least one power die or power module according to the sign of the output of the subtracting means.

**Patentansprüche**

1. Verfahren zum Erhöhen der Lebensdauer von wenigstens zwei Leistungschips oder Leistungsmodulen, wobei das Verfahren die folgenden Schritte umfasst:

- Erfassen der Temperatur der Leistungschips oder der Leistungsmodule,
- Identifizieren, für jeden Leistungschip oder jedes Leistungsmodul, von Temperaturzyklen aus den erfassten Temperaturen,
- Bestimmen, für jeden Leistungschip oder jedes Leistungsmodul, von Ausfallsicherheits- bzw. Zuverlässigkeitsparametern aus den identifizierten Temperaturzyklen,
- Bestimmen, für jeden Leistungschip oder jedes Leistungsmodul, von Referenztemperaturen unter Verwendung der Zuverlässigkeitsparameter,
- Subtrahieren, für jeden Leistungschip oder jedes Leistungsmodul, der erfassten Temperatur des Leistungschips oder Leistungsmoduls von der bestimmten Referenztemperatur des Leistungschips oder Leistungsmoduls,

- Einstellen der Dauer der Leitungszeit und/oder der Umschaltverzögerung von wenigstens einem Leistungschip oder Leistungsmodul gemäß dem Vorzeichen der Ausgabe des Subtraktionsschritts.

2. Verfahren nach Anspruch 1, **dadurch gekennzeichnet, dass**, für jeden Leistungschip oder jedes Leistungsmodul, der Temperaturzyklus gleich der Temperaturdifferenz zwischen der letzten erfassten lokalen maximalen Temperatur und einer anfänglichen Temperatur ist, die als eine letzte lokale minimale Temperatur bestimmt wird.

3. Verfahren nach Anspruch 1 oder 2, **dadurch gekennzeichnet, dass** die Zuverlässigkeitsparameter R1 und R2 bestimmt werden als:

$$R1 = \alpha_1 . \Delta T_1^{\beta_1}$$

$$R2 = \alpha_2 . \Delta T_2^{\beta_2}$$

wobei $\alpha_1$, $\alpha_2$, $\beta_1$ und $\beta_2$ Zuverlässigkeitskonstanten sind, die aus Tests bezüglich eines Aus- und wieder Einschaltens von Leistung bestimmt werden können und an durch den Hersteller der Leistungschips oder Leistungsmodule bereitgestellte Testdaten angepasst werden können, und $\Delta T_1$ und $\Delta T_2$ die jeweiligen Temperaturzyklen der Leistungschips oder Leistungsmodule sind.

4. Verfahren nach Anspruch 3, **dadurch gekennzeichnet, dass** die Referenztemperatur von einem Leistungschip oder Leistungsmodul durch Annehmen bestimmt wird, dass ein Verhältnis zwischen den Temperaturzyklusamplituden gleich dem Verhältnis zwischen der Sperrschichttemperatur der Leistungschips oder Leistungsmodule zur Umgebungstemperatur ist, und durch Abgleichen der Zuverlässigkeitsparameter der Leistungschips oder Leistungsmodule.

5. Verfahren nach Anspruch 1 oder 2, **dadurch gekennzeichnet, dass** die Zuverlässigkeitsparameter aus Lebensdauermodellen *Nf1* und *Nf2* bestimmt werden, die ausgedrückt werden können als:

$$Nf1 = \alpha_1 . \Delta T_1^{\beta_1}$$

$$Nf2 = \alpha_2 . \Delta T_2^{\beta_2}$$

wobei $\alpha_1$, $\alpha_2$, $\beta_1$ und $\beta_2$ Zuverlässigkeitskonstanten sind, die aus Tests bezüglich eines Aus- und wieder Einschaltens von Leistung bestimmt werden können und an durch den Hersteller der Leistungschips oder Leistungsmodule bereitgestellte Testdaten angepasst werden können, und $\Delta T_1$ und $\Delta T_2$ die jeweiligen Temperaturzyklen der Leistungschips oder Leistungsmodule sind, und die Zuverlässigkeitsparameter R1 und R2 bestimmt werden als:

$$R1 = \sum_{i=1}^{i=N} \frac{n_i(\Delta T_1)}{Nf1(\Delta T_1)}$$

$$R2 = \sum_{i=1}^{i=N} \frac{n_i(\Delta T_2)}{Nf2(\Delta T_2)}$$

wobei $n_i(\Delta T_1)$ und $n_i(\Delta T_2)$ die Anzahl von Zyklen bei $\Delta T_1$ und $\Delta T_2$ darstellen.

6. Verfahren nach Anspruch 5, **dadurch gekennzeichnet, dass** die Referenztemperatur jedes Leistungschips oder Leistungsmoduls durch Erhöhen oder Erniedrigen des Temperaturzyklus des Leistungschips oder Leistungsmoduls um ein Inkrement gemäß einem Vergleich der Zuverlässigkeit und durch Summieren des erhöhten oder erniedrigten Temperaturzyklus zu einer vorbestimmten Temperatur bestimmt wird.

7. Verfahren nach Anspruch 5, **dadurch gekennzeichnet, dass** die Referenztemperatur jedes Leistungschips oder Leistungsmoduls bestimmt wird durch eine berechnete Schadensänderungsrate des Zuverlässigkeitsparameters des Leistungschips oder Leistungsmoduls und durch Abgleichen der Schadensänderungsrate, wobei die Schadensänderungsraten berechnet werden als:

$$\frac{\partial R1}{\partial t} = \frac{\partial \left( \frac{1}{\alpha_1} . \Delta T_1^{-\beta_1} \right)}{\partial t}$$

$$\frac{\partial R2}{\partial t} = \frac{\partial \left( \frac{1}{\alpha_2} . \Delta T_2^{-\beta_2} \right)}{\partial t}$$

und durch Bestimmen, für jeden Leistungschip oder jedes Leistungsmodul, eines Inkrements von Temperatur, das die Differenz zwischen der Schadensänderungsrate des Leistungschips oder Leistungsmoduls und dem Durchschnittswert der Schadensänderungsraten minimiert, und durch Summieren des Inkrements von Temperatur des Leistungschips oder Leistungsmoduls zu einer vorbestimmten Temperatur.

8. Verfahren nach Anspruch 1 oder 2, **dadurch gekennzeichnet, dass** die Zuverlässigkeitsparameter aus einem A-priori-Wissen über ein Lebensdauermodell bestimmt werden als:

$$R1 = \frac{ln(l_0 - a_{1,0}) - ln(l_0 - a_{1,1})}{\gamma_1 \Delta T_1{}^2}$$

$$R2 = \frac{ln(l_0 - a_{2,0}) - ln(l_0 - a_{2,1})}{\gamma_2 \Delta T_2{}^2}$$

wobei $\gamma_1$ und $\gamma_2$ aus zwei unterschiedlichen Anzahlen von Temperaturzyklen bestimmt werden, $a_{1,0}$ und $a_{1,1}$ eine Längenwertänderung einer Bruchstelle einer Verbindung eines ersten Leistungschips darstellen, $a_{2,0}$ und $a_{2,1}$ eine Längenwertänderung einer Bruchstelle einer Verbindung eines zweiten Leistungschips darstellen, $\Delta T_1$ der Temperaturzyklus des ersten Leistungschips oder Leistungsmoduls ist und $\Delta T_2$ der Temperaturzyklus des zweiten Leistungschips oder Leistungsmoduls ist.

9. Verfahren nach Anspruch 8, **dadurch gekennzeichnet, dass** die Referenztemperatur jedes Leistungschips oder Leistungsmoduls bestimmt wird durch Erhöhen oder Erniedrigen des Temperaturzyklus des Leistungschips oder Leistungsmoduls um ein Inkrement gemäß einem Vergleich der Zuverlässigkeit und durch Summieren des erhöhten oder erniedrigten Temperaturzyklus zu einer vorbestimmten Temperatur.

10. Verfahren nach Anspruch 1 oder 2, **dadurch gekennzeichnet, dass** die Zuverlässigkeitsparameter aus einem A-priori-Wissen über ein Lebensdauermodell bestimmt werden als:

$$\frac{da_1}{dN} = \gamma_1 . \Delta K_1{}^{\delta_1}$$

$$\frac{da_2}{dN} = \gamma_2 . \Delta K_2{}^{\delta_2}$$

wobei $\Delta K_1$ und $\Delta K_2$ die Spannungsintensitätsfaktoren für die Leistungschips sind, die jeweils eine Funktion der Temperaturzyklen $\Delta T_1$ und $\Delta T_2$ sind, und wobei eine Optimierung verwendet wird, um die Systemlebensdauer zu verlängern, so dass die Referenztemperaturen mit dem Ziel berechnet werden, die Ausfallkriterien der Leistungschips gleichzeitig unter Verwendung von Spannungsintensitätsfaktoren von beiden Leistungschips $\Delta K_{ref1}$ und $\Delta K_{ref2}$ zu erreichen, die basierend auf der Lösung der folgenden zwei Hauptgleichungen berechnet sind:

$$a_2(N_1) - a_1(N_1) = \int_{N_1}^{N_f} \gamma_1 . \Delta K_{ref1}{}^{\delta_1} dN - \int_{N_2}^{N_f} \gamma_2 . \Delta K_{ref2}{}^{\delta_2} dN$$

$$N_f - N_1 = \int_{a_1(N_1)}^{a_f} \frac{da_1}{\gamma_1 . \Delta K_{ref1}{}^{\delta_1}} = \int_{a_2(N_1)}^{a_f} \frac{da_2}{\gamma_2 . \Delta K_{ref2}{}^{\delta_2}}$$

wobei N1 eine gegebene Anzahl von Zyklen vor der Systemlebensdauerverlängerung darstellt, wobei N1 zwischen 1 und Nf, was die Anzahl von Zyklen bis zu einem Ausfall der Leistungschips darstellt, ausgewählt wird.

11. System zum Erhöhen der Lebensdauer von wenigstens zwei Leistungschips oder Leistungsmodulen, wobei das System folgendes umfasst:

   - Mittel zum Erfassen der Temperatur der Leistungschips oder der Leistungsmodule,
   - Mittel zum Identifizieren, für jeden Leistungschip oder jedes Leistungsmodul, von Temperaturzyklen aus den erfassten Temperaturen,
   - Mittel zum Bestimmen, für jeden Leistungschip oder jedes Leistungsmodul, von Ausfallsicherheits- bzw. Zuverlässigkeitsparametern aus den identifizierten Temperaturzyklen,
   - Mittel zum Bestimmen, für jeden Leistungschip oder jedes Leistungsmodul, von Referenztemperaturen unter Verwendung der Zuverlässigkeitsparameter,
   - Mittel zum Subtrahieren, für jeden Leistungschip oder jedes Leistungsmodul, der erfassten Temperatur des Leistungschips oder Leistungsmoduls von der bestimmten Referenztemperatur des Leistungschips oder Leistungsmoduls,
   - Mittel zum Einstellen der Dauer der Leitungszeit und/oder der Umschaltverzögerung von wenigstens einem Leistungschip oder Leistungsmodul gemäß dem Vorzeichen der Ausgabe des Subtraktionsmittels.

## Revendications

1. Procédé permettant d'augmenter la durée de vie d'au moins deux puces d'alimentation ou modules d'alimentation, le procédé comprenant les étapes consistant à :

   détecter la température des puces d'alimentation ou des modules d'alimentation, identifier, pour chaque puce d'alimentation ou module d'alimentation, des cycles de température à partir des températures détectées,
   déterminer, pour chaque puce d'alimentation ou module d'alimentation, des paramètres de fiabilité à partir des cycles de température identifiés,
   déterminer, pour chaque puce d'alimentation ou module d'alimentation, des températures de référence, au moyen des paramètres de fiabilité,
   soustraire, pour chaque puce d'alimentation ou module d'alimentation, de la température de référence déterminée de la puce d'alimentation ou du module d'alimentation, la température détectée de la puce d'alimentation ou du module d'alimentation,
   régler la durée du temps de conduction et/ou du délai de commutation d'au moins une puce d'alimentation ou un module d'alimentation selon le signe de la sortie de l'étape de soustraction.

2. Procédé selon la revendication 1, **caractérisé en ce que**, pour chaque puce d'alimentation ou module d'alimentation, le cycle de température est égal à la différence de température entre la dernière température maximale locale détectée et une température initiale qui est déterminée comme étant une dernière température minimale locale.

3. Procédé selon la revendication 1 ou 2, **caractérisé en ce que** les paramètres de fiabilité R1 et R2 sont déterminés comme suit :

$$R1 = \alpha_1 . \Delta T_1^{\beta_1}$$

$$R2 = \alpha_2 . \Delta T_2^{\beta_2}$$

où $\alpha 1$, $\alpha 2$, $\beta 1$ et $\beta 2$ sont des constantes de fiabilité qui peuvent être déterminées à partir de tests de cycles d'alimentation et ajustées selon des données de test fournies par le fabricant des puces d'alimentation ou des modules d'alimentation, et $\Delta T_1$ et $\Delta T_2$ sont les cycles de température respectifs des puces d'alimentation ou des modules d'alimentation.

4. Procédé selon la revendication 3, **caractérisé en ce que** la température de référence d'une puce d'alimentation ou d'un module d'alimentation est déterminée en supposant qu'un rapport entre les amplitudes de cycle de température est égal au rapport entre la température de jonction des puces d'alimentation ou des modules d'alimentation et la température ambiante, et en égalisant les paramètres de fiabilité des puces d'alimentation ou des modules d'alimentation.

5. Procédé selon la revendication 1 ou 2, **caractérisé en ce que** les paramètres de fiabilité sont déterminés à partir de modèles de durée de vie *Nf*1 et *Nf*2 qui peuvent être exprimés comme suit :

$$Nf1 = \alpha_1 . \Delta T_1^{\beta_1}$$

$$Nf2 = \alpha_2 . \Delta T_2^{\beta_2}$$

où $\alpha 1$, $\alpha 2$, $\beta 1$ et $\beta 2$ sont des constantes de fiabilité qui peuvent être déterminées à partir de tests de cycles d'alimentation et ajustées selon des données de test fournies par le fabricant des puces d'alimentation ou des modules d'alimentation, $\Delta T_1$ et $\Delta T_2$ sont les cycles de température respectifs des puces d'alimentation ou des modules d'alimentation, et les paramètres de fiabilité R1 et R2 sont déterminés comme suit :

$$R1 = \sum_{i=1}^{i=N} \frac{n_i (\Delta T_1)}{Nf1(\Delta T_1)}$$

$$R2 = \sum_{i=1}^{i=N} \frac{n_i (\Delta T_2)}{Nf2(\Delta T_2)}$$

où $n_i(\Delta T_1)$ et $n_i(\Delta T_2)$ représentent le nombre de cycles à $\Delta T_1$ et $\Delta T_2$.

6. Procédé selon la revendication 5, **caractérisé en ce que** la température de référence de chaque puce d'alimentation ou module d'alimentation est déterminée en augmentant ou en diminuant le cycle de température de la puce d'alimentation ou du module d'alimentation d'un incrément selon une comparaison de la fiabilité et en additionnant le cycle de température augmenté ou diminué à une température prédéterminée.

7. Procédé selon la revendication 5, **caractérisé en ce que** la température de référence de chaque puce d'alimentation ou module d'alimentation est déterminée par un taux de variation d'endommagement calculé du paramètre de fiabilité de la puce d'alimentation ou du module d'alimentation, et en équilibrant les taux de variation d'endommagement, les taux de variation d'endommagement étant calculés comme suit :

$$\frac{\partial R1}{\partial t} = \frac{\partial(\frac{1}{\alpha_1}.\Delta T_1^{-\beta 1})}{\partial t}$$

$$\frac{\partial R2}{\partial t} = \frac{\partial(\frac{1}{\alpha_2}.\Delta T_2^{-\beta 2})}{\partial t}$$

et en déterminant, pour chaque puce d'alimentation ou module d'alimentation, un incrément de température qui minimise la différence entre le taux de variation d'endommagement de la puce d'alimentation ou du module d'alimentation et la valeur moyenne des taux de variation d'endommagement, et en additionnant l'incrément de température de la puce d'alimentation ou du module d'alimentation à une température prédéterminée.

8. Procédé selon la revendication 1 ou 2, **caractérisé en ce que** les paramètres de fiabilité sont déterminés à partir d'une connaissance *a priori* d'un modèle de durée de vie, comme suit :

$$R1 = \frac{\ln(l_0 - a_{1,0}) - \ln(l_0 - a_{1,1})}{\gamma_1 \Delta T_1^2}$$

$$R2 = \frac{\ln(l_0 - a_{2,0}) - \ln(l_0 - a_{2,1})}{\gamma_2 \Delta T_2^2}$$

où $\gamma_1$ et $\gamma_2$ sont déterminés à partir de deux nombres différents de cycles de température, $a_{1,0}$ et $a_{1,1}$ représentent une variation de valeur de longueur d'une fissure d'une connexion d'une première puce d'alimentation, $a_{2,0}$ et $a_{2,1}$ représentent une variation de valeur de longueur d'une fissure d'une connexion d'une seconde puce d'alimentation, $\Delta T_1$ est le cycle de température de la première puce d'alimentation ou du premier module d'alimentation et $\Delta T_2$ est le cycle de température de la seconde puce d'alimentation ou du second module d'alimentation.

9. Procédé selon la revendication 8, **caractérisé en ce que** la température de référence de chaque puce d'alimentation ou module d'alimentation est déterminée en augmentant ou en diminuant le cycle de température de la puce d'alimentation ou du module d'alimentation d'un incrément selon une comparaison de la fiabilité et en additionnant le cycle de température augmenté ou diminué à une température prédéterminée.

10. Procédé selon la revendication 1 ou 2, **caractérisé en ce que** les paramètres de fiabilité sont déterminés à partir d'une connaissance *a priori* d'un modèle de durée de vie, comme suit :

$$\frac{da_1}{dN} = \gamma_1.\Delta K_1^{\delta_1}$$

$$\frac{da_2}{dN} = \gamma_2.\Delta K_2^{\delta_2}$$

où $\Delta K_1$ et $\Delta K_2$ sont les facteurs d'intensité de contrainte des puces d'alimentation en fonction respectivement des cycles de température $\Delta T_1$ et $\Delta T_2$, et une optimisation étant utilisée pour prolonger la durée de vie du système, de telle sorte que les températures de référence soient calculées avec l'objectif d'atteindre les critères de défaillance des puces d'alimentation en même temps au moyen des facteurs d'intensité de contrainte $\Delta K_{ref1}$ et $\Delta K_{ref2}$ des deux puces d'alimentation, calculés sur la base de la solution des deux équations principales suivantes :

$$a_2(N_1) - a_1(N_1) = \int_{N_1}^{N_f} \gamma_1.\Delta K_{ref1}^{\delta_1}\, dN - \int_{N_2}^{N_f} \gamma_2.\Delta K_{ref2}^{\delta_2}\, dN$$

$$N_f - N_1 = \int_{a_{1(N_1)}}^{a_f} \frac{da_1}{\gamma_1.\ \Delta K_{ref1}^{\delta_1}} = \int_{a_{2(N_1)}}^{a_f} \frac{da_2}{\gamma_2.\ \Delta K_{ref2}^{\delta_2}}$$

où $N_1$ représente un nombre donné de cycles avant la prolongation de la durée de vie du système, $N_1$ étant choisi entre 1 et $N_f$ et représentant le nombre de cycles jusqu'à une défaillance des puces d'alimentation.

11. Système permettant d'augmenter la durée de vie d'au moins deux puces d'alimentation ou modules d'alimentation, le système comprenant :

un moyen permettant de détecter la température des puces d'alimentation ou des modules d'alimentation,
un moyen permettant d'identifier, pour chaque puce d'alimentation ou module d'alimentation, des cycles de température à partir des températures détectées,
un moyen permettant de déterminer, pour chaque puce d'alimentation ou module d'alimentation, des paramètres de fiabilité à partir des cycles de température identifiés,
un moyen permettant de déterminer, pour chaque puce d'alimentation ou module d'alimentation, des températures de référence, au moyen des paramètres de fiabilité,
un moyen permettant de soustraire, pour chaque puce d'alimentation ou module d'alimentation, de la température de référence déterminée de la puce d'alimentation ou du module d'alimentation, la température détectée de la puce d'alimentation ou du module d'alimentation,
un moyen permettant de régler la durée du temps de conduction et/ou du délai de commutation d'au moins une puce d'alimentation ou un module d'alimentation selon le signe de la sortie du moyen de soustraction.

Fig. 1a

Fig. 1b

Fig. 1c

Fig. 1d

Fig. 1e

**Fig. 2**

**Fig. 3**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2020236823 A1

- EP 3054306 A1

**Non-patent literature cited in the description**

- Closed Loop Junction Temperature Control of Power Transistors for Lifetime Extension. **RUTHARDT JO-HANNES et al.** 2020 IEEE APPLIED POWER ELECTRONICS CONFERENCE AND EXPOSITION (APEC). IEEE, 15 March 2020, 2955
- Railway traction reliability. **MICHEL MERMET-GUY-ENNET et al.** INTEGRATED POWER ELECTRON-ICS SYSTEMS (CIPS), 2010 6TH INTERNATIONAL CONFERENCE ON. IEEE, 16 March 2010, 1-6

- **R. GOPIREDDY ; L. M. TOLBERT ; B. OZPINECI ; J. O. P. PINTO.** Rainflow Algorithm-Based Lifetime Estimation of Power Semiconductors in Utility Appli-cations. *IEEE Transactions on Industry Applications,* July 2015, vol. 51 (4), 3368-3375